(19)

Europäisches Patentamt

European Patent Office

Office européen des brevets

(11)  **EP 4 529 354 A1**

(12)  # EUROPEAN PATENT APPLICATION

(43) Date of publication:
26.03.2025  Bulletin 2025/13

(21) Application number: 23198681.1

(22) Date of filing: 21.09.2023

(51) International Patent Classification (IPC):
H05B 45/56 (2020.01)     G05B 23/02 (2006.01)
G01R 31/392 (2019.01)    G01R 31/26 (2020.01)

(52) Cooperative Patent Classification (CPC):
H05B 45/56; G01R 31/392; G05B 23/0283

(84) Designated Contracting States:
AL AT BE BG CH CY CZ DE DK EE ES FI FR GB
GR HR HU IE IS IT LI LT LU LV MC ME MK MT NL
NO PL PT RO RS SE SI SK SM TR
Designated Extension States:
BA
Designated Validation States:
KH MA MD TN

(71) Applicant: Tridonic GmbH & Co KG
6851 Dornbirn (AT)

(72) Inventors:
• Amann, Günter
6850 Dornbirn (AT)

• Schmölzer, Andreas
6850 Dornbirn (AT)
• Kernbichler, Elias
6850 Dornbirn (AT)
• Zengerle, Thomas
6850 Dornbirn (AT)
• Hüttinger, Ulrich
6850 Dornbirn (AT)

(74) Representative: Beder, Jens
Mitscherlich PartmbB
Patent- und Rechtsanwälte
Karlstraße 7
80333 München (DE)

(54)  **METHOD FOR MONITORING THE CONDITION OF LIGHTING DEVICES**

(57)    The present invention relates to an operating device configured to provide a supply voltage and/or current to an illuminant (2), to generate or receive, for each time interval of successive time intervals, a temperature signal indicating at least one temperature value, to determine, for each time interval, whether the time interval is assignable to at least one temperature class of a plurality of temperature classes based on the at least one temperature value and to increment or decrement a counter value of each temperature class to which a time interval is assignable.

FIG. 1

**Description**

The invention relates to an apparatus and a method for estimating usage history of a component of a lighting system. More specifically, the invention relates to an operating device for an illuminant and a method for recording thermal stress of the component.

In lighting systems, operating devices (converters, ballasts, driver devices) are used for providing a supply voltage and/or current to an illuminant. State-of-the-art LED converters can also provide device information about their current operating status (e.g., active power, LED voltage, LED current, control gear temperature, etc.).

EP 4 057 780 A1 discloses a lighting system comprising such LED converters and a control device that predicts a malfunction of an LED converter based on the device information provided by the LED converter. The LED converter can be an emergency converter that stores information on the result of a function test or an operational duration test (endurance test) and continually collects and stores information about the temperature of the rechargeable battery, which provides energy to the emergency converter if main power supply fails for a period of up to three hours, for example.

While in other applications (e.g., smart phones, electric cars) charging and discharging have a major impact on battery life, in emergency lighting the batteries are usually fully charged most of the time and kept in trickle charge mode. Discharging and charging rarely takes place, only after a power failure or during planned operational duration tests once to four times a year. Therefore, the ambient temperature is the most important factor influencing the battery life.

Battery manufacturers usually specify different battery lifes for different temperature ranges. The same often applies to the converters. Using this manufacturer's information and a record of operating temperature over time, the equivalent operating hours of the battery and/or the converter can be estimated and the remaining life predicted. For this purpose, however, temperatures recorded by the converter must be read out at short intervals, since the capacity of the internal data memory is usually insufficient to store temperature data over a longer period of time.

It is an object of the present invention to overcome the above mentioned drawbacks and to provide an improved lighting system. More specifically, it is an object of the invention to provide an operating device and a method, with which information about the thermal load of components of a lighting system can be provided with low effort and costs.

This object is achieved by an operating device and a method according to the enclosed independent claims. Advantageous features of the present invention are defined in the corresponding subclaims.

According to the present invention, the operating device is configured to provide a supply voltage and/or current to an illuminant, to generate or receive, for each time interval of successive time intervals, a temperature signal indicating at least one temperature value, to determine, for each time interval, whether the time interval is assignable to at least one temperature class of a plurality of temperature classes based on the at least one temperature value and to increment or decrement a counter value of each temperature class to which a time interval is assignable.

With the present invention, information about thermal loads occurring over a long period of time is stored in the form of a histogram, wherein the temperature classes correspond to types of thermal loads to be recorded and the count value indicates the number of occurred thermal loads of the respective type. In this way, only the number of specific thermal loads is recorded and there is no need to store time series data over a longer period. Merely for the assignment to a class and/or the determination of the length of the time interval it may be necessary to store/buffer time series data until the assignment or determination is completed.

At least a part of the temperature classes can correspond to different adjacent temperature ranges such as the temperature ranges described above for different lifetimes. For this, only one temperature value can be determined periodically in each time interval.

Alternatively, the operating device can be configured to store/buffer a plurality of temperature values indicated by the temperature signal for a time interval, to calculate an average temperature of the plurality of temperature values for the time interval, to determine whether the time interval is assignable to the at least one temperature class based on the average temperature of the time interval, to increment or decrement the counter value of each temperature class to which the time interval is assignable and to enable deleting or overwriting the plurality of stored temperature values immediately after the average temperature has been calculated.

The number and/or width of the temperature ranges can be adapted by the manufacturer to the type of component to be monitored and/or its location (e.g., indoor/outdoor). Alternatively or additionally, this can be done by the user or automatically by the operating device in a setup mode started manually by the user or automatically after the power supply is switched on, wherein the operating device can be configured to adjust at least a part of the temperature ranges based on an user input and/or to evaluate a distribution of the counter values over the temperature classes and to adjust at least a part of the temperature ranges based on the evaluated distribution. In this way, it can be recognized that the component is operated indoors and the detection of temperatures below o degrees Celsius is not necessary.

Alternatively or additionally, the time interval can be adapted to the type of component and/or its location (e.g. fluctuating temperatures), wherein the operating device can be configured to adjust the time interval based on an user input and/or to evaluate a distribution of the counter values over the temperature classes and to adjust the time interval based on the evaluated distribution.

Thermal stresses can also be temperature fluctuations, whereby high temperature fluctuations can damage solder joints, for example. To monitor this, at least some of the temperature classes can correspond to different temperature changes per time unit.

In addition, the operating device can be configured to store a plurality of temperature values indicated by the temperature signal for a time interval, to calculate the temperature change ($\Delta T$) for the time interval based on the plurality of temperature values, to determine whether the time interval is assignable to the at least one temperature class based on the calculated temperature change, to increment or decrement the counter value of each temperature class to which the time interval is assignable and to enable deleting or overwriting the plurality of stored temperature values immediately after the temperature change has been calculated.

These temperature classes can be adapted to the type of component and/or its location, wherein the operating device is configured to adjust the temperature change of one or more temperature classes based on a user input and/or to evaluate a distribution of the counter values over the temperature classes and to adjust the temperature change of the temperature class(es) based on the evaluated distribution.

Temperature change can be caused, for example, by a warm-up or cool-down phase after a switching operation, whereby the rise or fall in temperature may be non-linear or non-monotonic. To detect the total temperature change/cycle, the operating device can be configured to determine the temperature cycle in the temperature signal using Rainflow Counting Algorithm and to set the time interval corresponding to the determined temperature cycle.

In addition to data processing for the histogram, the operating device can also evaluate the histogram data periodically or on demand. In this way, when each temperature class is assigned to a different service life, the operating device can be configured to predict remaining service life based on the counter values of the temperature classes. The predicted remaining service life can be stored and/or outputted. Alternatively or in addition, the operating device can be configured to output a warn signal when the predicted remaining service life is less than a threshold.

The component to be monitored can be the operating device itself, wherein an internal or external sensor generates the temperature signal indicating a temperature inside the operating device.

Alternatively or in addition, the operating device can be an emergency converter configured to provide the supply voltage and/or current using energy stored in an energy storage device, wherein the operating device comprises an energy storage interface configured to connect the operating device to the energy storage device. The energy storage interface can be configured to connect to a temperature sensor of the energy storage device that generates the temperature signal. Alternatively, an internal sensor generates the temperature signal indicating the temperature of the operating device and the temperature sensor of the energy storage device generates another temperature signal indicating the temperature of the energy storage device, wherein the operating device generates a first histogram based on the temperature signal and a second histogram based on the other temperature signal.

In addition, the operating device can be configured to predict the remaining service life of the energy storage device based on the second histogram.

The functions described herein may be implemented using individual hardware circuitry, using software functioning in conjunction with at least one of a programmed microprocessor, a general purpose computer, using an application specific integrated circuit (ASIC) and using one or more digital signal processors (DSPs).

According to the present invention, the method for controlling an operating device, which is configured to provide a supply voltage and/or current to an illuminant, comprises the steps of:

- generating or receiving, for each time interval of successive time intervals, a temperature signal indicating at least one temperature value,
- determining, for each time interval, whether the time interval is assignable to at least one temperature class of a plurality of temperature classes based on the at least one temperature value, and
- incrementing or decrementing a counter value of each temperature class to which a time interval is assignable.

The operating device can comprise a control circuit, which is advantageously a microcontroller or a dedicated ASIC and is configured to execute the steps of the controlling method.

According to the present invention, a program that, when running on a computer (the microcontroller/ASIC) or loaded onto a computer, causes the computer to execute the steps of the controlling method.

Embodiments of the invention are discussed in detail with reference to the enclosed figures, in which

FIG. 1 shows a simplified block diagram of parts of an operating device according to a first embodiment of the present invention,

FIG. 2 shows a simplified block diagram of parts of an operating device according to a second embodiment of the present invention,

FIG. 3 shows a table in which information about thermal loads is recorded by the converter device shown in FIG. 2,

FIG. 4 shows a diagram of a temperature signal and cycles of the temperature signal determined using the Rainflow algorithm,

FIG. 5 shows a histogram of the counting results for the cycles shown FIG. 4, and

FIG. 6 shows a flowchart of the method according to an embodiment of the present invention.

In the figures, same reference numbers denote same or equivalent structures. The explanation of structures with same reference numbers in different figures is avoided where deemed possible for sake of conciseness.

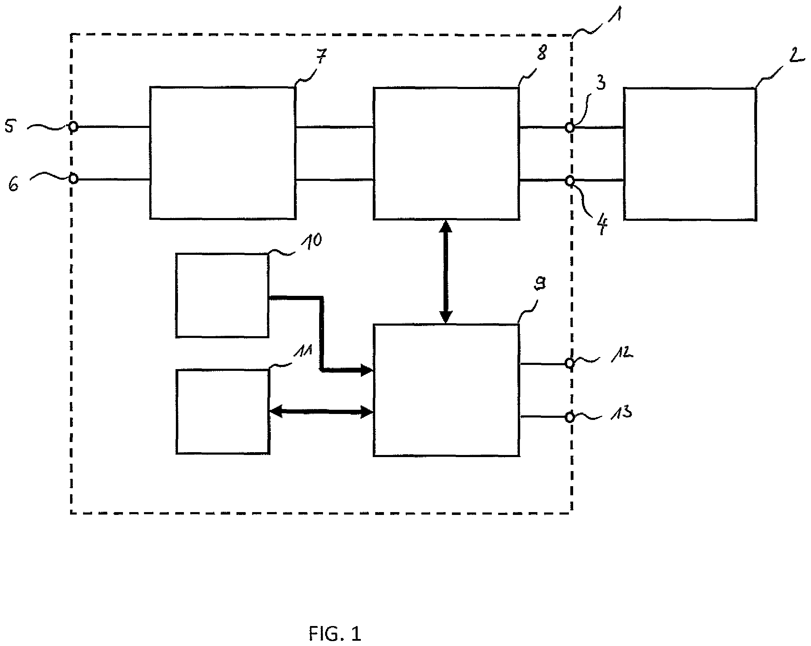

FIG. 1 shows an operating device 1 according to a first embodiment of the present invention. The operating device 1 is a LED converter 1 detachably connected to a LED lighting device 2 and comprises a light device terminal 3, 4 (connectors) for connecting the LED lighting device 2 to the operating device 1, mains terminal 5, 6 (connectors) for connecting the operating device 1 to the mains supply, a rectifier and Power-factor correction (PFC) circuit 7 connected to the mains terminal 5, 6 and a LED driver 8 that includes at least one DC-to-DC converter for generating LED drive current for the LED lighting device 2 using the DC voltage generated by the rectifier and Power-factor correction (PFC) circuit 7. The LED drive current generated by the LED driver 8 is output via the light device terminal 3, 4 to the LED lighting device 2 and the LED lighting device 2 fed with the LED light current emits light from one or more LEDs (not shown).

The operating device 1 shown in Fig. 1 further comprises a control circuit 9, which is advantageously a microcontroller circuit or a dedicated application specific integrated circuit (ASIC), a temperature sensor 10, a storage means 11 (nonvolatile memory) and a control terminal 12, 13 (connectors) for connecting the operating device 1 to a data bus (e.g., DALI) or an output device (e.g., a display).

The temperature sensor 10 is located within the housing (not shown) of the operating device 1, detects the temperature of at least one of the rectifier and Power-factor correction (PFC) circuit 7, the LED driver 8, the control circuit 9 and the storage means 11, generates a temperature signal indicating the detected temperature and provides the temperature signal to the control circuit 9.

The control circuit 9 is configured to continuously detect thermal load/stress at predetermined times based on the temperature signal and to classify the detected thermal load/stress to record information about detected thermal load/stress in the form of a histogram/table stored in the storage means 11. The histogram/table indicates how many hours or minutes the operating device 1 has been operated to date in each of a plurality of the temperature ranges. This enables the user to see to which extent the operating device 1 has been operated in a thermally stressful environment. The temperature can be monitored as soon as mains supply is connected to the mains terminal 5, 6 or only when the LED drive current is generated by the LED driver 8.

As described above the number and/or width of the temperature ranges can be adapted to the device type, the location (e.g., indoor/outdoor) and/or the manufacturer's specifications. Typical temperature ranges are [50°C, ..., 60°C), [60°C, ..., 70°C), [70°C, ..., 80°C), [80°C, ..., 90°C) and [60°C, ..., 100°C]. In the histogram/table, each temperature range contains a counter that is incremented by one when the operating device 1 has been operated in the corresponding temperature range for, say, five minutes, wherein the control circuit 9 can calculate an average temperature of each time interval of five minutes or take only a single value, especially if no large temperature variations are expected during the time interval. The temperature range to which the calculate/detected value belongs is determined and the counter of the determined temperature range is increased.

In addition or alternatively, temperature change in each time interval can be determined based on at least two temperature values and then classified, wherein the ranges/classes for the temperature change within the time interval can be [0°C, ..., 10°C), [10°C, ..., 20°C), [20°C, ..., 30°C), [30°C, ..., 40°C) and [40°C, ..., 50°C]. The histogram(s)/table(s) stored in the storage means 11 is output via the control terminal 12, 13 and/or analyzed by the control circuit 12 to output a warn signal if the counter of predetermined temperature range(s) and/or the counter of predetermined temperature change(s) exceeds a threshold. The operating device 1 can comprise an NFC reader/writer (transponder) configured to store the histogram(s)/table(s) so that the information can be read out by a mobile device, such as a tablet, laptop or smart phone, when the operating device 1 is not operating or defective.

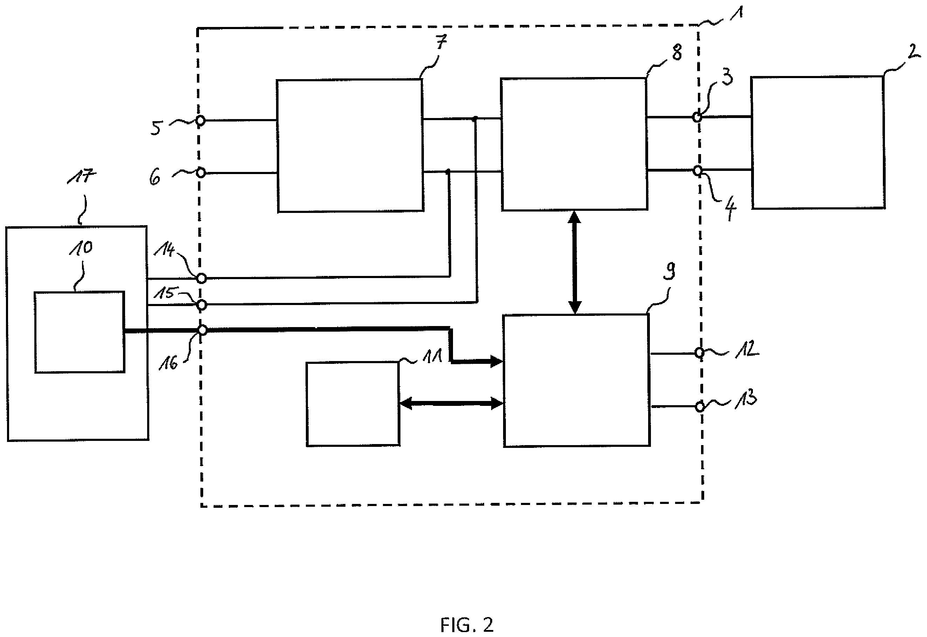

FIG. 2 shows an operating device 1 according to a second embodiment of the present invention. The operating device 1 shown in FIG. 2 is an emergency converter detachably connected to the LED lighting device 2 (emergency lighting means) and comprises an energy storage interface 14..16 configured to connect an energy storage device 17 to the operating device 1. The parts shown in Fig. 2 can be housed in an emergency luminaire, which operates in maintained lighting mode or non-maintained lighting mode. The LED lighting device 2 is used for a conventional lighting as well as for the emergency lighting in the maintained lighting mode. In the non-maintained lighting mode, except for test purposes, the LED lighting device 2 is only used for the emergency lighting, i.e., the LED lighting device 2 is only switched on if the mains supply fails and the drivers of main lighting devices are not supplied with power.

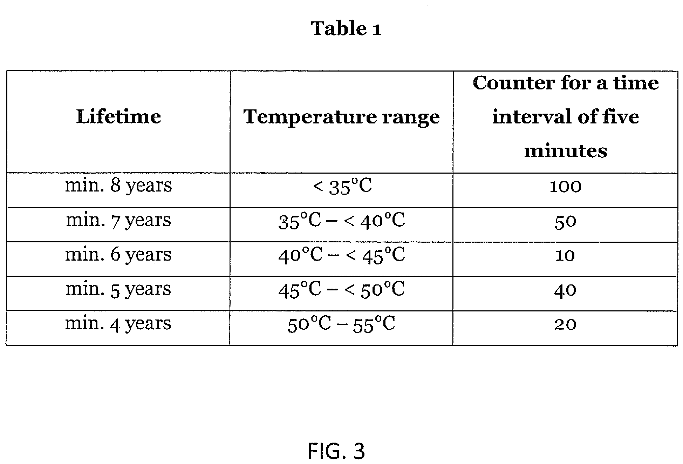

The energy storage device 17 comprises the temperature sensor 10 and the energy storage interface 14..15 is configured to connect to the temperature sensor 10 that generates the temperature signal indicating the temperature of the energy storage device 17. The control circuit 9 receives the temperature signal via the energy storage interface 14..15, continuously detects the temperature of the energy storage device 17 and classifies the detected temperature in temperature ranges. FIG. 3 shows a table 1 in which the temperature ranges correspond to different lifetimes (service life) of the energy storage device 17.

As described above, the temperature is measured once or preferably several times in each interval of five minutes and an average value is calculated from the several measured values. The (average) value is compared with the temperature ranges shown in Table 1 and, if the (average) value can be assigned to a temperature range, the corresponding counter, which is set to 0 at the beginning of the operating time recording, is incremented by one. Alternatively, each counter value can be incremented by a value that corresponds to the lifetime of the respective temperature range, e.g., the counter for temperature range < 35°C (min. 8 years) is incremented by one and the counter for temperature range 50°C - 55°C (min. 4 years) is incremented by two, so that the total consumed lifetime can be determine by calculating the sum of the (weighted) counters.

As shown in Table 1, the temperature of the energy storage device 17 was monitored for 1100 minutes (220 • 5 minutes), with the energy storage device 17 operating in the temperature range of 50°C - 55°C for a total of 100 minutes (20 • 5 minutes). In this way, each counter corresponds to a score of consumed lifetime and the control circuit 9 is configured to weight the scores/counters based on the different lifetimes of temperature ranges and to estimate the lifetime of the energy storage device 17 by combining the weighted scores/counters. Preferably, the control circuit 9 calculates a predicted lifetime by

$$predicted\ lifetime = \frac{1}{n} \cdot \sum_{i=1}^{n} x_i \cdot H(x_i),$$

where n is the total number of counter values, $x_i$ is the counter value for a specific temperature range and H is the lifetime for a specific temperature range. With regard to the counters in Table 1, the predicted lifetime is calculated:

$$predicted\ lifetime = \frac{100 \cdot 8 + 50 \cdot 7 + 10 \cdot 6 + 40 \cdot 5 + 20 \cdot 4}{220} = 6,4\ years.$$

The control circuit 9 outputs the predicted lifetime of 6,4 years via the control terminal 12, 13. Alternatively or in addition, the control circuit 9 outputs a warning signal when the predicted lifetime is less than a threshold.

By using counters, the amount of data to be stored to cover the maximum lifetime is small. With regard to the counters in Table 1, if a maximal lifetime of 10 years (8 years + 2 years buffer) is assumed, the memory space for each of the five counters must be reserved for only 5256000 counts. I.e., 23 bits per counter and rounded to bytes results in an additional memory requirement of 15 bytes in total.

The temperature sensor 10 shown in FIG. 1 and FIG. 2 is located inside the operating device 1 and the energy storage device 17, respectively. However, it is also possible to place the temperature sensor 10 outside the operating device 1 and the energy storage device 17, respectively, to measure/monitor the ambient temperature.

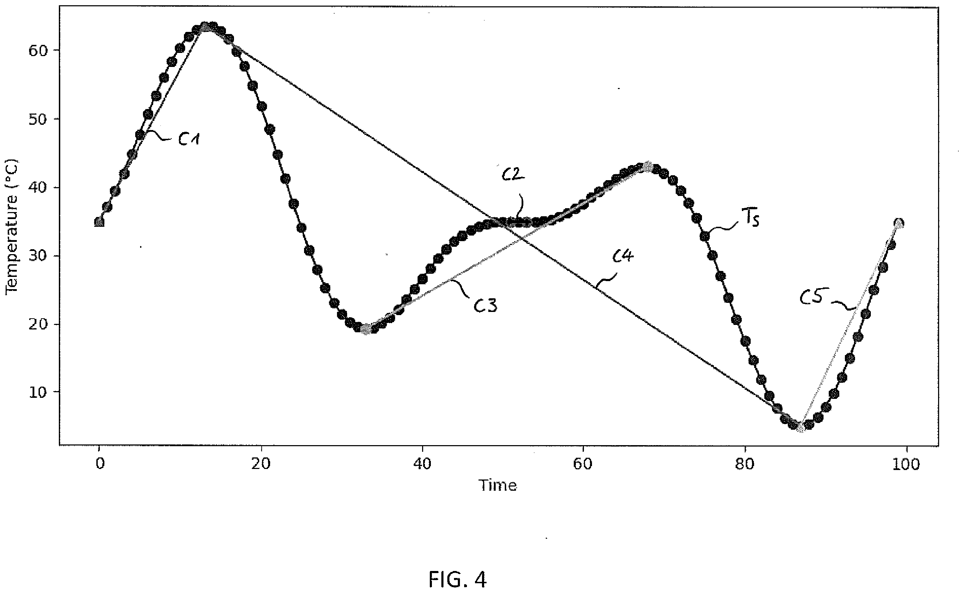

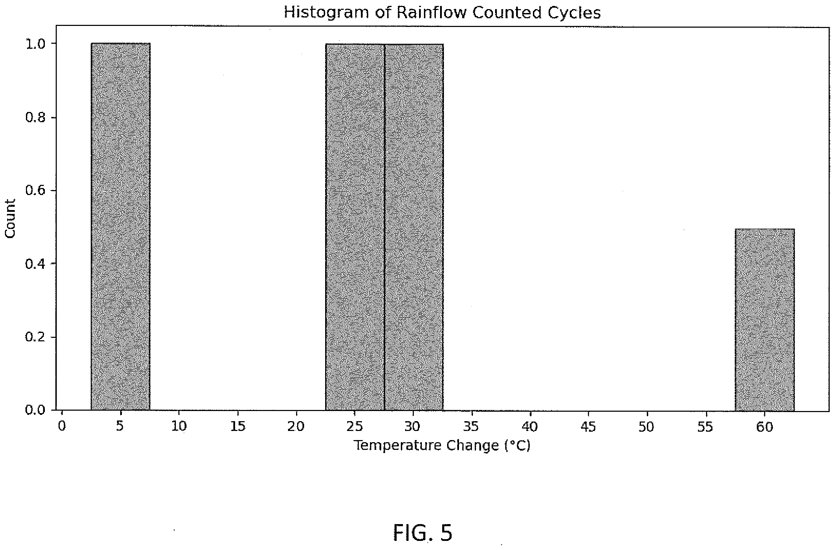

In electronics, solder joints may be subject to fatigue due to recurring temperature fluctuations. The Rainflow algorithm, which is typically used to convert stress sequences into distinct stress cycles, can be applied to these temperature variations to evaluate solder joint longevity and predict potential failures. FIG. 4 shows a diagram of a temperature signal Ts generated by the temperature sensor 10 and cycles of the temperature signal determined using the Rainflow algorithm that identifies both, half-cycles and full cycles. In the diagram, the cycles are marked by straight lines, wherein half cycle C1 has a temperature change of 30°C, full cycle C2 has a temperature change of 5°C, full cycle C3 has a temperature change of 25°C, half cycle C4 has a temperature change of 60°C and half cycle C5 has a temperature change of 30°C. FIG. 5 shows the counting results for the cycles C1..C5 in a histogram. With the histogram data, the remaining lifetime can be calculated by

$$RLT = -\sum_{i=1}^{n} \frac{\Delta t_i}{ELT(T_i, const)} + 1$$

where *RTL* is an indicator for the remaining lifetime, n is the total number of counter values (bins), $T_i$ is the representative temperature of bin i, and $\Delta ti$ is the count (hours of time) in bin i.

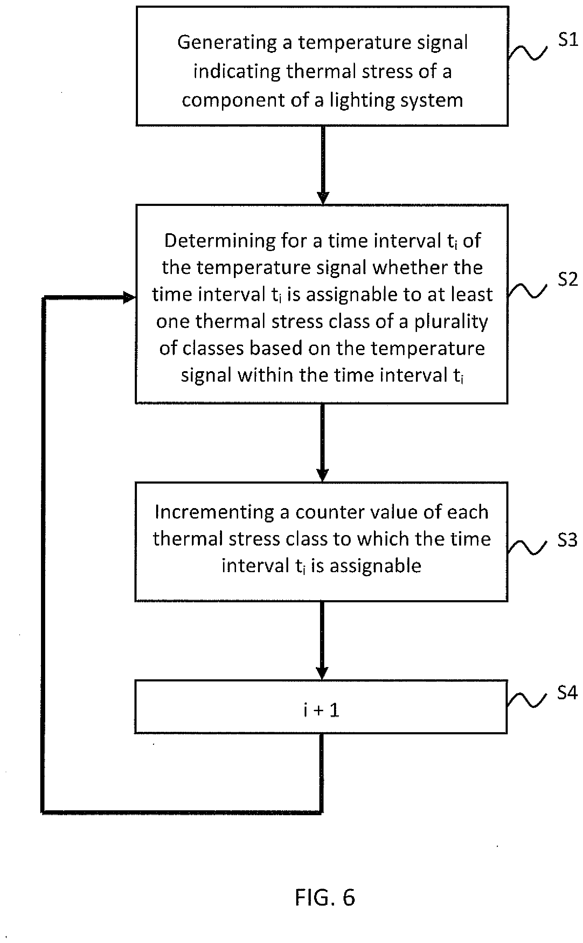

FIG. 6 shows a simplified flowchart showing the single steps performed by the realization of the method described in detail above. In step S1, the temperature sensor 10 generates the temperature signal. In step S2, the temperature signal of the first time interval is analyzed with respect to a plurality of thermal stress classes and a counter value of thermal stress class to which the first time interval is assignable is incremented in step S3. In step S4, the next time interval is selected and steps S2 to S4 are executed again for this interval.

**Claims**

1. An operating device configured to provide a supply voltage and/or current to an illuminant (2), to generate or receive, for each time interval of successive time intervals, a temperature signal indicating at least one temperature value, to determine, for each time interval, whether the time interval is assignable to at least one temperature class of a plurality of temperature classes based on the at least one temperature value and to increment or decrement a counter value of each temperature class to which a time interval is assignable.

2. The operating device according to claim 1, wherein
   at least a part of the temperature classes correspond to different adjacent temperature ranges.

3. The operating device according to claim 2, wherein
   the operating device (1) is configured to store a plurality of temperature values indicated by the temperature signal for a time interval, to calculate an average temperature of the plurality of temperature values for the time interval, to determine whether the time interval is assignable to the at least one temperature class based on the average temperature of the time interval, to increment or decrement the counter value of each temperature class to which the time interval is assignable and to enable deleting or overwriting the plurality of store temperature values immediately after the average temperature has been calculated.

4. The operating device according to claim 2 or 3, wherein
   the operating device (1) is configured to adjust at least a part of the temperature ranges based on an user input and/or to evaluate a distribution of the counter values over the temperature classes and to adjust at least a part of the temperature ranges based on the evaluated distribution.

5. The operating device according to any one of preceding claims, wherein
   the operating device (1) is configured to adjust the time interval based on an user input and/or to evaluate a distribution of the counter values over the temperature classes and to adjust the time interval based on the evaluated distribution.

6. The operating device according to any one of preceding claims, wherein
   at least a part of the temperature classes correspond to different temperature changes per unit of time.

7. The operating device according to claim 6, wherein
   the operating device (1) is configured to store a plurality of temperature values indicated by the temperature signal for a time interval, to calculate the temperature change for the time interval based on the plurality of temperature values, to determine whether the time interval is assignable to the at least one temperature class based on the calculated temperature change, to increment or decrement the counter value of each temperature class to which the time interval is assignable and to enable deleting or overwriting the plurality of store temperature values immediately after the temperature change has been calculated.

8. The operating device according to claim 6 or 7, wherein
   the operating device (1) is configured to adjust the temperature change of at least one the temperature class based on an user input and/or to evaluate a distribution of the counter values over the temperature classes and to adjust the temperature change of at least one the temperature class based on the evaluated distribution.

9. The operating device according to claim 6, 7 or 8, wherein
   the operating device (1) is configured to determine a temperature cycle in the temperature signal using a Rainflow Counting Algorithm and to set the time interval corresponding to the determined temperature cycle.

10. The operating device according to any one of preceding claims, wherein
    each temperature class is assigned to a different service life and the operating device (1) is configured to predict remaining service life based on the counter values of the temperature classes.

11. The operating device according to claim 10, wherein
the operating device (1) is configured to store the predicted remaining service life, to output the predicted remaining service life, and/or to output a warn signal when the predicted remaining service life is less than a threshold.

12. The operating device according to any one of preceding claims, comprising
a sensor (10) for generating the temperature signal, wherein the temperature signal indicates a temperature inside the operating device (1).

13. The operating device according to claim 12 and 10 or 11, wherein
the operating device (1) is configured to predict the remaining service life of the operating device (1).

14. The operating device according to any one of claims 1 to 11, wherein

the operating device (1) is an emergency converter configured to provide the supply voltage and/or current using energy stored in an energy storage device (17),
the operating device (1) comprises an energy storage interface (14..16) configured to connect the operating device (1) to the energy storage device (17), and
the energy storage interface (14..16) is configured to connect to a temperature sensor (10) of the energy storage device (17) that generates the temperature signal.

15. The operating device according to claim 14 and 10 or 11, wherein
the operating device (1) is configured to predict the remaining service life of the energy storage device (17).

16. A method for controlling an operating device (1) configured to provide a supply voltage and/or current to an illuminant (2), comprising the steps of:

generating or receiving (S1), for each time interval of successive time intervals, a temperature signal indicating at least one temperature value,
determining (S2), for each time interval, whether the time interval is assignable to at least one temperature class of a plurality of temperature classes based on the at least one temperature value, and
incrementing or decrementing (S3) a counter value of each temperature class to which a time interval is assignable.

FIG. 1

FIG. 2

**Table 1**

| Lifetime | Temperature range | Counter for a time interval of five minutes |
|---|---|---|
| min. 8 years | < 35°C | 100 |
| min. 7 years | 35°C – < 40°C | 50 |
| min. 6 years | 40°C – < 45°C | 10 |
| min. 5 years | 45°C – < 50°C | 40 |
| min. 4 years | 50°C – 55°C | 20 |

FIG. 3

FIG. 4

EP 4 529 354 A1

Histogram of Rainflow Counted Cycles

FIG. 5

EP 4 529 354 A1

Generating a temperature signal indicating thermal stress of a component of a lighting system — S1

Determining for a time interval $t_i$ of the temperature signal whether the time interval $t_i$ is assignable to at least one thermal stress class of a plurality of classes based on the temperature signal within the time interval $t_i$ — S2

Incrementing a counter value of each thermal stress class to which the time interval $t_i$ is assignable — S3

i + 1 — S4

FIG. 6

**EUROPEAN SEARCH REPORT**

Europäisches Patentamt
European Patent Office
Office européen des brevets

Application Number

EP 23 19 8681

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | WO 2022/248532 A1 (UNIV DANMARKS TEKNISKE [DK]) 1 December 2022 (2022-12-01) | 1,2,4,5, 10-16 | INV. H05B45/56 |
| Y | * the whole document * | 3,6-9 | G05B23/02 G01R31/392 |
| Y | MUSALLAM M ET AL: "An Efficient Implementation of the Rainflow Counting Algorithm for Life Consumption Estimation", IEEE TRANSACTIONS ON RELIABILITY, IEEE SERVICE CENTER, PISCATAWAY, NJ, US, vol. 61, no. 4, 1 December 2012 (2012-12-01), pages 978-986, XP011481271, ISSN: 0018-9529, DOI: 10.1109/TR.2012.2221040 * the whole document * | 3,7 | G01R31/26 |
| Y | CHAUDHARY SANJAY ET AL: "Field Data logger prototype for power converters", 2014 IEEE INTERNATIONAL CONFERENCE ON POWER ELECTRONICS, DRIVES AND ENERGY SYSTEMS (PEDES), IEEE, 16 December 2014 (2014-12-16), pages 1-4, XP032736835, DOI: 10.1109/PEDES.2014.7042058 ISBN: 978-1-4799-6372-0 [retrieved on 2015-02-12] * the whole document * | 6-9 | |
| E | EP 4 304 298 A1 (TRIDONIC GMBH & CO KG [AT]) 10 January 2024 (2024-01-10) * the whole document * | 1,2,4,6, 8-13,16 | |

**TECHNICAL FIELDS SEARCHED (IPC)**

G05B
H05B
G01R

-/--

The present search report has been drawn up for all claims

| Place of search | Date of completion of the search | Examiner |
|---|---|---|
| Munich | 18 March 2024 | Ferla, Monica |

EPO FORM 1503 03.82 (P04C01)

3

## EUROPEAN SEARCH REPORT

Application Number

EP 23 19 8681

### DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| A | RAHIMPOUR SAEED ET AL: "An Overview of Lifetime Management of Power Electronic Converters", IEEE ACCESS, IEEE, vol. 10, 12 October 2022 (2022-10-12), pages 109688-109711, XP011924133, DOI: 10.1109/ACCESS.2022.3214320 [retrieved on 2022-10-13] * the whole document * | 1-16 | |
| | ----- | | |

TECHNICAL FIELDS
SEARCHED      (IPC)

The present search report has been drawn up for all claims

| Place of search | Date of completion of the search | Examiner |
|---|---|---|
| Munich | 18 March 2024 | Ferla, Monica |

CATEGORY OF CITED DOCUMENTS

X : particularly relevant if taken alone
Y : particularly relevant if combined with another
    document of the same category
A : technological background
O : non-written disclosure
P : intermediate document

T : theory or principle underlying the invention
E : earlier patent document, but published on, or
    after the filing date
D : document cited in the application
L : document cited for other reasons

& : member of the same patent family, corresponding
    document

EPO FORM 1503 03.82 (P04C01)

**EP 4 529 354 A1**

## ANNEX TO THE EUROPEAN SEARCH REPORT
## ON EUROPEAN PATENT APPLICATION NO.

**EP 23 19 8681**

This annex lists the patent family members relating to the patent documents cited in the above-mentioned European search report.
The members are as contained in the European Patent Office EDP file on
The European Patent Office is in no way liable for these particulars which are merely given for the purpose of information.

**18-03-2024**

| Patent document cited in search report | Publication date | Patent family member(s) | Publication date |
|---|---|---|---|
| WO 2022248532 A1 | 01-12-2022 | NONE | |
| EP 4304298 A1 | 10-01-2024 | EP 4304298 A1 | 10-01-2024 |
| | | WO 2024008462 A1 | 11-01-2024 |

For more details about this annex : see Official Journal of the European Patent Office, No. 12/82

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- EP 4057780 A1